# EUROPEAN PATENT APPLICATION

(11) **EP 0 647 966 A1**
(43) Date of publication of application: **12.04.1995**
(21) Application number: 94115789.3
(22) Date of filing: 06.10.1994
(51) Int. Cl.: H01L 21/321

(54) **Semiconductor device with wiring pattern and method for manufacturing same**

(30) Priority: 06.10.1993 JP 250493/93
(71) Applicant: KABUSHIKI KAISHA TOSHIBA, Kawasaki-shi, Kanagawa-ken 210 (JP)
(72) Inventor: Chida, Kousaku, Waga-gun, Iwate-ken (JP); Hirano, Yoshiharu, Kitakami-shi, Iwate-ken (JP); Chiba, Takuya, Iwate-ken (JP); Araya, Bunsaku, Kitakami-shi, Iwate-ken (JP)
(74) Representative: Lehn, Werner, Dipl.-Ing.

(57) **Abstract**

A semiconductor device has a dummy pattern (5) in a region close to the functional circuit module (2). The dummy pattern is of the same material as the wiring pattern (3) and is made simultaneously with the wiring pattern.

A method of manufacturing the semiconductor device has a step of simultaneous forming of a wiring pattern in a functional circuit module and a dummy wiring pattern in a region close to the functional circuit module.

## Description

### BACKGROUND OF THE INVENTION

This invention relates to a semiconductor device and a method of manufacturing the semiconductor device.

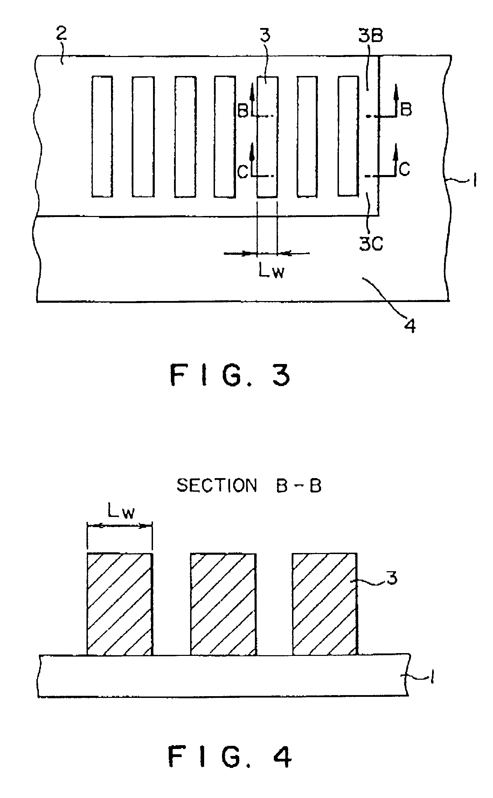

In a conventional semiconductor device as shown in Fig. 3, a functional module 2 having wirings 3 is formed on a semiconductor substrate 1, e.g. silicon substrate. It is quite general to obtain such wiring patterns by performing a reactive ion etching (RIE) method using reactive gas, e.g. CF₄.

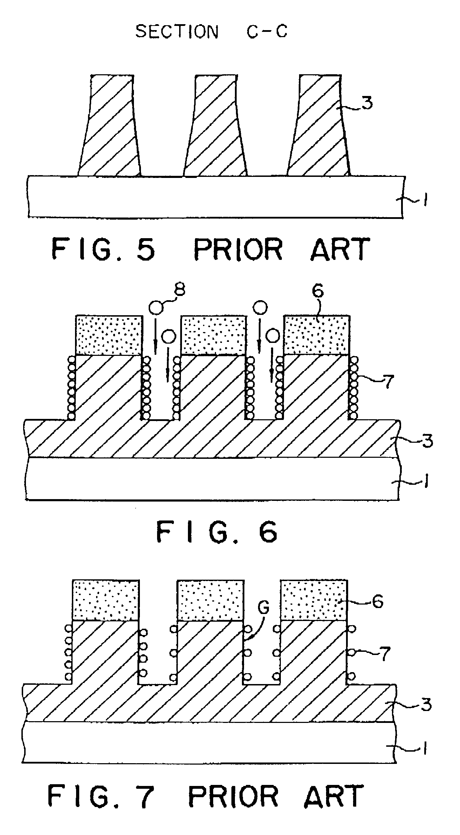

Recent progress in miniaturization and integration of semiconductor has reduced width L_{w} (See Fig. 3) of wirings. Accordingly, in the case that wiring patterns are formed by RIE, there causes difference in sectional pattern configuration between portions at or near the end 3C of the wiring 3 which is near to sparse region 4 and at or near the inner part 3B of the wiring 3. More specifically, a sectional pattern configuration at the part 3B near inner part of the wiring shows a normal sectional pattern configuration as shown in Fig. 4 which is a sectional view along the line B-B. However, sectional pattern configuration at the end 3C of the wiring shows large side etching (See Fig. 5) which results in smaller dimension comparing to a desired width L_{w} (See Fig. 3).

Such phenomenon can be explained as follows: In the case of forming wiring patterns using the RIE method, firstly a photoresist pattern 6 is formed by resist application and photoengraving then the wiring layer is etched by reactive ions using the photoresist pattern as an etching mask. At the part 3B near inner part, sides of the wiring patterns 3 are covered by protective side walls against etching. The protective side walls are compound (for example carbide) films 7 which are generated by reaction between reactive ions 8 and photoresist 6 as shown in Fig. 6. In contrast, at the end part 3C, since the part is close to sparse region 4, amount of the compound is small because reaction between the reactive ions 8 and the photoresist 6 is not go active. Accordingly the sides of the wiring patterns are not perfectly covered by the compound resulting in generating non-covered portions or spacing G from where the etching proceeds.

Thus side etchings occurred in the wiring patterns may cause an electromigration, reduction of reliability, deterioration in characteristics, and decrease in yield. Furthermore, the adverse effect of the side etching becomes serious especially for patterns having width of submicron (which is under 1 micrometer) order because the more develops the miniaturization the less becomes the width of patterns.

### Summary of the Invention

Accordingly, it is the object of the invention to provide a semiconductor device which can prevent deterioration of characteristics and improve reliability.

It is another object of the invention to provide a method for manufacturing such semiconductor device.

According to the present invention, there is provided
a semiconductor device comprising:
a functional circuit module having a wiring pattern on a semiconductor substrate; and
a dummy wiring pattern of the same material of the wiring pattern formed in a region close to the wiring pattern on the semiconductor substrate, the dummy wiring pattern being formed simultaneously with the wiring pattern.

According to the present invention, there is also provided
a manufacturing method of a semiconductor device comprising the steps of:
forming a functional circuit module in a functional circuit module region on a semiconductor substrate;
depositing material of wiring and dummy wiring on the semiconductor substrate;
performing patterning the material in the functional circuit module region to obtain wiring pattern and in a region close to the functional circuit module to simultaneously obtain dummy wiring pattern.

### Brief Description of the Drawings

In the attached drawings:
Fig. 1 is a plan view showing configuration of an embodiment of the semiconductor device according to the present invention.
Fig. 2 is a sectional view of the semiconductor device shown in Fig. 1 cut along the line A-A.
Fig. 3 is a plan view showing configuration of conventional semiconductor devices.
Fig. 4 is a sectional view of the semiconductor device shown in Fig. 3 cut along the line B-B.
Fig. 5 is a sectional view of the semiconductor device shown in Fig. 3 cut along the line C-C.
Fig. 6 is a sectional view of an inner part of a wiring pattern of a conventional semiconductor device, which has been formed by the RIE method.
Fig. 7 is a sectional view of an end part of the wiring pattern of the conventional semiconductor device, which has been formed by the RIE method.

### Description of the Preferred Embodiment

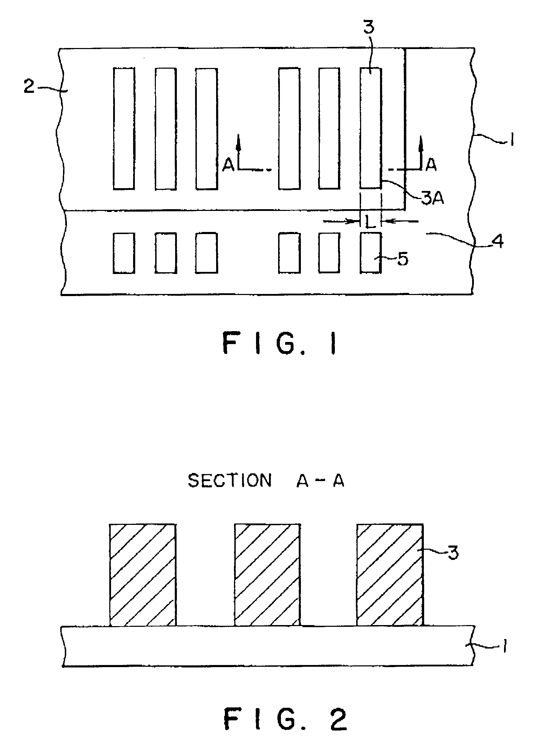

Fig. 1 shows a plan view of a semiconductor device of the present invention. The semiconductor device according to this embodiment has a functional circuit module 2 formed on a semiconductor substrate 1.

The functional circuit module usually has an analog circuit (for example, A/D converter circuit) and a repeated circuit (for example, a memory circuit), etc. Such a functional circuit module is made using an ordinary well known wafer process, such as sputtering process, CVD(Chemical Vapor Deposition) process, photoengraving process, etc.

In the functional module, wiring patterns 3 having width of L are formed by depositing wiring material e.g. aluminium, copper, doped silicon, aluminium alloy, copper alloy and by patterning the wiring material using the RIE method.

In a region 4 where there is also formed relatively fewer patterns (sparse region), a dummy wiring pattern which has the same or similar configuration as that of the wiring pattern 3 is provided. This dummy wiring pattern 5 is formed simultaneously with the above-mentioned wiring pattern 3 using the RIE method. The material of the wiring pattern 3 is the same as the material of the dummy wiring pattern 5, which is for example, aluminium or polysilicon.

In such a semiconductor device, a cross sectional configuration of the end part of the wiring pattern which is close to the sparse region becomes normal.

This can be explained as follows:
Since there is formed a dummy pattern having the same or similar configuration as that of the wiring pattern in the sparse region, side walls of compound film 7 which is formed by reaction between reactive ions 8 and photoresist 6 at the sides of the pattern and such side walls prevent the pattern from being etched as shown in Fig. 6.

It is to be noted that the dummy wiring pattern 5 may preferably be close to the wiring pattern 3 in order that the protective wall may well be formed.

The dummy wiring pattern may be removed after the RIE patterning of the wiring pattern has been completed.

As described above, the present invention can provide a highly reliable semiconductor device which can prevent deterioration of characteristics.

## Claims

1. A semiconductor device comprising a functional circuit module (2) having a wiring pattern (3) on a semiconductor substrate (1); characterized in that said device futher comprises a dummy wiring pattern (5) of the same material of said wiring pattern formed in a region (4) close to said wiring pattern on the semiconductor substrate, said dummy wiring pattern being formed simultaneously with said wiring pattern.

2. The semiconductor device according to claim 1, wherein said wiring pattern (3) and said dummy wiring pattern (5) have similar pattern configuration.

3. A manufacturing method of a semiconductor device comprising the steps of:
forming a functional circuit module (2) in a functional circuit module region on a semiconductor substrate (1);
depositing material of wiring and dummy wiring on said semiconductor substrate;
performing patterning of said material in said functional circuit module region to obtain a wiring pattern and in a region close to said functional circuit module to obtain a dummy wiring pattern.

4. A manufacturing method of a semiconductor device according to claim 3, wherein said method further comprises a step of removing said dummy wiring pattern after completing said patterning.
